# EUROPEAN PATENT APPLICATION

(11) **EP 4 507 467 A1**
(43) Date of publication of application: **12.02.2025**
(21) Application number: 23799221.9
(22) Date of filing: 28.04.2023
(51) Int. Cl.: H05K 7/20

(54) **HEAT DISSIPATION APPARATUS AND BASE STATION DEVICE**

(30) Priority: 05.05.2022 CN 202210478291
(71) Applicant: ZTE Corporation, Shenzhen, Guangdong 518057 (CN)
(72) Inventor: WANG, Jian, Shenzhen, Guangdong 518057 (CN); HU, Maoxin, Shenzhen, Guangdong 518057 (CN); SUN, Weihua, Shenzhen, Guangdong 518057 (CN); YIN, Shangbao, Shenzhen, Guangdong 518057 (CN); CHENG, Yanyan, Shenzhen, Guangdong 518057 (CN); LIAO, Ruochen, Shenzhen, Guangdong 518057 (CN); CHENG, Fei, Shenzhen, Guangdong 518057 (CN); LIU, Zhaohu, Shenzhen, Guangdong 518057 (CN); ZHU, Yue, Shenzhen, Guangdong 518057 (CN)
(74) Representative: Canzler & Bergmeier Patentanwälte Partnerschaft mbB
(86) International application number: PCT/CN2023/091497
(87) International publication number: WO 2023/213235

(57) **Abstract**

The present disclosure provides a heat dissipation apparatus. The heat dissipation apparatus comprises a heat dissipation body. The heat dissipation apparatus further comprises an enhanced heat dissipation assembly. The enhanced heat dissipation assembly comprises at least one driving part and at least one vibration piece; each vibration piece is connected to a corresponding driving part; the driving part is configured to vibrate under an excitation condition and drive the vibration piece to vibrate, so as to form an airflow to assist the heat dissipation body to dissipate heat. The present disclosure further provides a base station device.

## Description

### CROSS-REFERENCE TO RELATED APPLICATIONS

This application claims the priority from Chinese Patent Application No. 202210478291.X filed on May 5, 2022, the disclosure of which is hereby incorporated by reference in its entirety.

### TECHNICAL FIELD

The present disclosure relates to the field of communication devices, and in particular, to a heat dissipation device and base station equipment including the heat dissipation device.

### BACKGROUND

With the advent of the 5G era, more and more 5G products are emerging. The 5G product involves a large amount of information exchange and relatively high power consumption, and the accompanying heat dissipation problem has become a bottleneck restricting the performance of the product.

How to provide a heat dissipation device with good heat dissipation performance for 5G products (or other similar electronic products involving high heat generation) has become an urgent technical problem to be solved in the field.

### SUMMARY

Embodiments of the present disclosure provide a heat dissipation device and base station equipment including the heat dissipation device.

As a first aspect of the present disclosure, there is provided a heat dissipation device including a heat dissipation body, wherein the heat dissipation device further includes an enhanced heat dissipation assembly including at least one driving part and at least one vibration piece, each vibration piece is connected to a corresponding driving part, and the driving part is configured to vibrate under an excitation condition and drive the vibration piece to vibrate, so as to form an airflow to assist heat dissipation through the heat dissipation body.

As a second aspect of the present disclosure, there is provided base station equipment including a heat dissipation device being the heat dissipation device of the present disclosure.

### BRIEF DESCRIPTION OF DRAWINGS

FIG. 1 is an exploded perspective view of an implementation of a heat dissipation device according to the present disclosure;
FIG. 2 is a front view of an implementation of a heat dissipation device according to the present disclosure;
FIG. 3 is a schematic diagram showing an implementation of a relationship between a heat dissipation body and an enhanced heat dissipation assembly;
FIG. 4 is a schematic diagram showing vibration of a vibration piece in an enhanced heat dissipation assembly;
FIG. 5 is a perspective structural view of an implementation of an enhanced heat dissipation assembly; and
FIG. 6 is an exploded perspective view of another implementation of a heat dissipation device according to the present disclosure.

### DETAIL DESCRIPTION OF EMBODIMENTS

To improve understanding of the technical solution of the present disclosure for those skilled in the art, the heat dissipation device and the base station equipment of the present disclosure will now be described in detail with the help of accompanying drawings.

Exemplary embodiments will be described more sufficiently below with reference to the accompanying drawings, but which may be embodied in different forms and should not be construed as limited to the embodiments set forth herein. Rather, these embodiments are provided so that the present disclosure will be thorough and complete, and will fully convey the scope of the present disclosure to those skilled in the art.

The embodiments, implementations and features thereof in the present disclosure may be combined with each other if there is no conflict.

As used herein, the term "and/or" includes any and all combinations of one or more of the associated listed items.

The terminology used herein is for the purpose of describing specific embodiments only and is not intended to limit the present disclosure. As used herein, the singular forms "a", "an" and "the" are intended to include the plural forms as well, unless the context clearly indicates otherwise. It will be further understood that as used herein, the terms "comprise" and/or "consist of ..." specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the existing art and the present disclosure, and will not be interpreted in an idealized or overly formal sense unless expressly so defined herein.

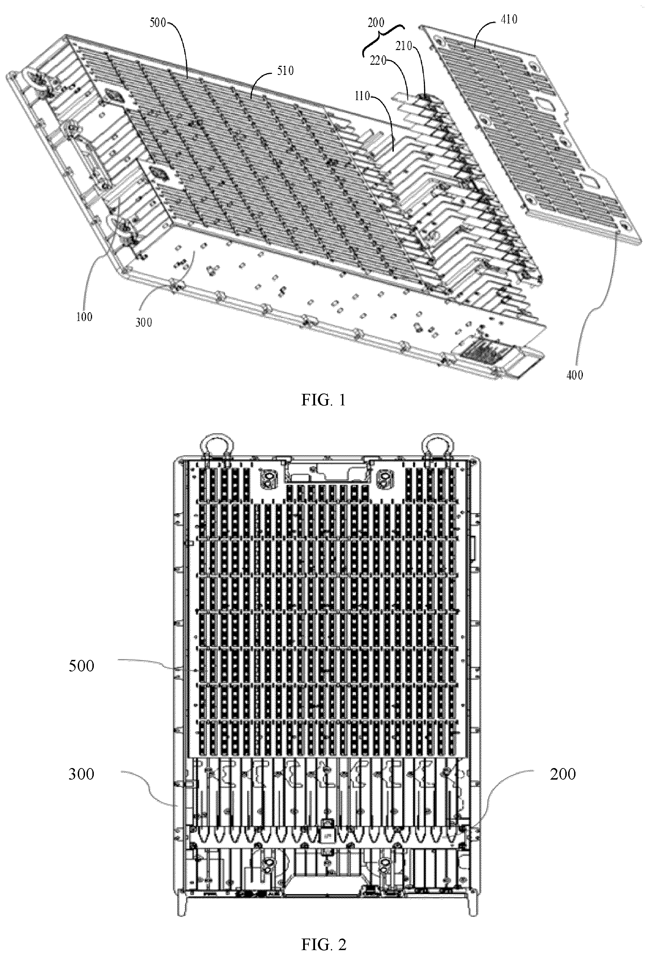

As a first aspect of the present disclosure, there is provided a heat dissipation device which, as shown in FIGs. 1, 2 and 6, includes a heat dissipation body 100. The heat dissipation device further includes an enhanced heat dissipation assembly 200 including at least one driving part 210 and at least one vibration piece 220. Each vibration piece 220 is connected to a corresponding driving part 210. The driving part 210 is configured to vibrate under an excitation condition and drive the corresponding vibration piece 220 to vibrate, so as to form an air flow assisting in heat dissipation through the heat dissipation body 100.

The vibration of the vibration piece 220 may drive the air to flow (i.e., form the air flow mentioned above), and when the flowing air passes through the heat dissipation body 100, heat on the heat dissipation body 100 can be transferred to the external surroundings (i.e., the heat dissipation body 100 is air-cooled by the enhanced heat dissipation assembly 200), so that the electronic device (e.g., base station equipment) with the heat dissipation device is cooled, and the heat dissipation effect is improved.

The enhanced heat dissipation assembly 200 drives the air to flow through vibration of the vibration piece 220, with relatively low friction applied to the vibration piece 220 in the vibration process (for example, the friction with a solid is at least partially eliminated), so that noise generated by the enhanced heat dissipation assembly 200 due to friction in use is also greatly reduced, and the enhanced heat dissipation assembly 200, as well as the heat dissipation device including the enhanced heat dissipation assembly 200, have the advantage of low noise.

Further, since very low friction is applied to the vibration piece 220 in the vibration process, abrasion of the vibration piece 220 is also very low, which enables a longer service life of the enhanced heat dissipation assembly 200.

In the present disclosure, the excitation condition is not particularly limited as long as the driving part 210 can be caused to vibrate under the excitation condition. For ease of implementation, as an alternative implementation, the excitation condition includes a periodically varying electric field. Accordingly, the driving part 210 may include an electric signal receiving portion and a connecting portion. The electric signal receiving portion is configured to receive the periodically varying electric field, the connecting portion is made of a piezoelectric material, the connecting portion is electrically connected to the electric signal receiving portion so that the electric signal receiving portion transmits the received electric field to the connecting portion, and the connecting portion is further connected to the vibration piece.

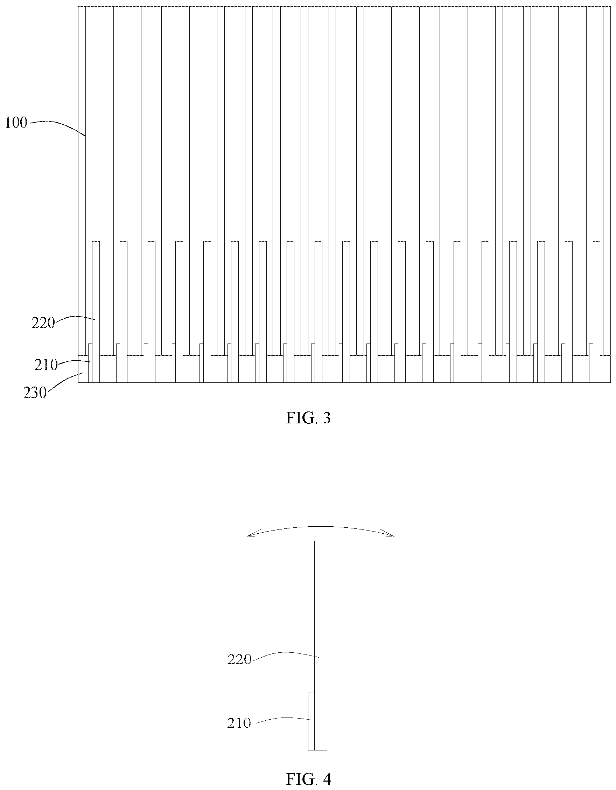

As described above, the connecting portion is made of a piezoelectric material having a piezoelectric effect and a reverse piezoelectric effect. The "reverse piezoelectric effect" means that a mechanical stress is generated when a voltage is applied to a piezoelectric material. That is, conversion between mechanical energy and electrical energy occurs. If a periodic electrical signal is applied to the piezoelectric material, the piezoelectric material will generate mechanical vibrations. As shown in FIG. 4, in some alternative implementations of the present disclosure, the vibration piece 220 has a fin shape, and can bring about an air flow while generating lateral mechanical vibration (i.e., the vibration direction (indicated by the double-headed arrow in FIG. 4) is substantially the same as a thickness direction of the vibration piece).

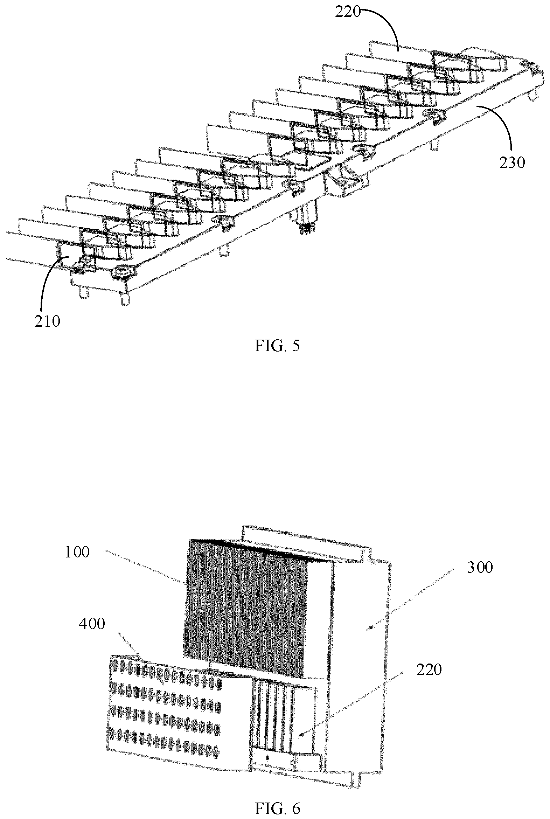

In the present disclosure, a specific arrangement of the vibration piece 220 is not particularly limited. To increase the flow rate of the air flow caused by the vibration of the vibration piece 220, as an alternative implementation, as shown in FIGs. 4 and 5, one end of the vibration piece 220 is connected to the connecting portion, and the other end of the vibration piece 220 is a free end.

In vibration of the vibration piece 220, the free end of the vibration piece 220 is vibrated at an amplitude greater than the end of the vibration piece 220 connected to the connecting portion, so that an air flow of a higher flow rate can be driven, and the heat dissipation effect can be improved.

**In** the present disclosure, the distribution of the heat dissipation body 100 and the enhanced heat dissipation assembly 200 in the heat dissipation device is not particularly limited, as long as the air flow generated by the enhanced heat dissipation assembly 200 can blow toward the heat dissipation body and take away the heat generated by the heat dissipation body. As an alternative implementation, the heat dissipation device further includes a heat dissipation case 300 on which the heat dissipation body 100 and the enhanced heat dissipation assembly 200 are provided.

The heat dissipation device can be fixed to the corresponding mounting base by means of the heat dissipation case 300, and the heat dissipation body 100 and the enhanced heat dissipation assembly 200 can be assembled together also by means of the heat dissipation case 300.

Generally, the heat dissipation case has a certain height. To facilitate more complete and thorough cooling of the heat dissipation body 100, as an alternative implementation, the enhanced heat dissipation assembly 200 may be provided at a bottom of the heat dissipation case 300. The enhanced heat dissipation assembly 200 drives air to flow at the bottom of the heat dissipation case 300 to form an air flow which may flow from the bottom of the heat dissipation case 300 to the top of the heat dissipation case 300 to achieve complete and thorough cooling of the heat dissipation body 100.

**In** the present disclosure, the specific structure of the heat dissipation body 100 is not particularly limited. As an alternative implementation, the heat dissipation body 100 may include a plurality of heat dissipation teeth 110 (heat dissipation teeth sheets) arranged at intervals. The intervals between the heat dissipation teeth 110 are formed as heat dissipation channels. To facilitate rapid passage of the air flow through the heat dissipation channels, as an alternative implementation, a length direction of the heat dissipation teeth 110 coincides with a length direction of the vibration piece. **In** other words, the air flow formed by means of the enhanced heat dissipation assembly 200 may directly enter the heat dissipation channels to take away heat rapidly, thereby implementing rapid cooling of the electronic equipment.

**In** the present disclosure, the specific structure of the heat dissipation teeth 110 is not particularly limited. For example, the heat dissipation teeth may be needle-shaped teeth sheets or columnar teeth sheets. Apparently, the arrangement of the heat dissipation teeth in the heat dissipation body 100 is not particularly limited in the present disclosure. For example, the plurality of heat dissipation teeth may be arranged in a straight manner or in a V-shaped manner.

In the present disclosure, the relative positions of the heat dissipation body 100 and the enhanced heat dissipation assembly 200 are not particularly limited, as long as the heat dissipation teeth 110 do not interfere with vibration of the vibration piece. In the implementation shown in FIG. 1, each vibration piece 220 is provided in a gap between two adjacent heat dissipation teeth 110. With such arrangement, a total volume of the heat dissipation body 100 and the enhanced heat dissipation assembly 200 is reduced, which is beneficial to miniaturization of the heat dissipation device on the premise of enhancing the cooling effect. In the present disclosure, the vibration piece 220 may be provided in parallel with the heat dissipation teeth 110.

Apparently, the present disclosure is not limited thereto, and in the implementation shown in FIG. 3, the enhanced heat dissipation assembly and the heat dissipation body are arranged in sequence in a height direction of the heat dissipation case.

To protect the enhanced heat dissipation assembly 200, as an alternative implementation, the heat dissipation device further includes an enhanced heat dissipation cover 400 fixedly connected to the heat dissipation case 300, an enhanced heat dissipation through hole 410 is formed in the enhanced heat dissipation cover 400, and the enhanced heat dissipation assembly 200 is provided in a space between the enhanced heat dissipation cover 400 and the heat dissipation case 300. The heat dissipation performance of the heat dissipation device can be improved by providing the enhanced heat dissipation through hole 410. In the present disclosure, the shape, number, and location of enhanced heat dissipation through holes 410 are not limited as long as the air circulation function is achieved.

Similarly, to protect the heat dissipation body 100, as an alternative implementation, the heat dissipation device may further include a heat dissipation body cover 500 fixedly connected to the heat dissipation case 300, at least part of the heat dissipation body 100 is located in a space between the heat dissipation case 300 and the heat dissipation body cover 500, and a body heat dissipation through hole 510 is formed in the heat dissipation body cover 500. Similar to the enhanced heat dissipation through hole 410, the body heat dissipation through hole 510 is also provided to improve the heat dissipation performance of the heat dissipation device. In the present disclosure, the specific location and number of body heat dissipation through holes 510 are not particularly limited, as long as the air circulation function is achieved. As an alternative implementation, the body heat dissipation through holes 510 is in communication with gaps between the heat dissipation teeth 110 to achieve a better heat dissipation effect.

**In** the present disclosure, the specific number of vibration pieces 220 is not particularly limited. To improve the heat dissipation effect, as an alternative implementation, the enhanced heat dissipation assembly 200 includes a plurality of vibration pieces 220, and accordingly, the enhanced heat dissipation assembly may further include a plurality of driving parts 210. Each of the vibration pieces 220 can induce an air flow and enhance the heat dissipation effect.

To facilitate provision of the plurality of vibration pieces 220 and the plurality of driving parts 210 in the heat dissipation device, as an alternative implementation, the enhanced heat dissipation assembly 200 further includes a setting plate 230 on which the plurality of vibration pieces 220 are arranged at intervals. The free end of each vibration piece 220 protrudes out of an edge of the setting plate 230, and the free end of each of the plurality of vibration pieces 220 faces a top of the heat dissipation case 300. **In** the present disclosure, the vibration piece 220 and the driving part 210 may be assembled on the setting plate 230 in advance to obtain the enhanced heat dissipation assembly 200, and then the assembled enhanced heat dissipation assembly 200 is assembled into the heat dissipation case 300 so that the assembly process of the entire heat dissipation device can be facilitated.

To facilitate positioning of the enhanced heat dissipation assembly 200 on the heat dissipation case 300, as an alternative implementation, a first positioning member may be provided on the heat dissipation case 300, a second positioning member may be provided on the setting plate 230, and the first positioning member is matched with the second positioning member.

**In** the present disclosure, the specific forms of the first positioning member and the second positioning member are not particularly limited, as long as rough positioning of the setting plate 230 on the heat dissipation case 300 can be implemented. For example, one of the first positioning member and the second positioning member is a positioning groove, while the other of the first positioning member and the second positioning member is a positioning protrusion that may be engaged into the positioning groove to implement positioning of the setting plate 230 on the heat dissipation case 300.

To implement precise positioning of the setting plate 230, as an alternative implementation, a fourth positioning member may be provided on the setting plate 230, a fifth positioning member may be provided on the heat dissipation case 300, and the fourth positioning member may be matched with the fifth positioning member to implement precise positioning of the setting plate 230 on the heat dissipation case 300.

As an alternative implementation, the fourth positioning member on the setting plate 230 may be a threaded hole, the fifth positioning member on the heat dissipation case 300 may be a through hole, and the heat dissipation device may further include a positioning bolt which is screwed in position with the fourth positioning member aligned with the corresponding fifth positioning member, thereby implementing precise positioning of the setting plate 230 on the heat dissipation case 300.

Apparently, the present disclosure is not limited thereto, and positioning of the setting plate 230 on the heat dissipation case 300 may also be implemented by other positioning members.

In the present disclosure, how to supply power to the driving part is not particularly limited, and to simplify the overall structure, as an alternative implementation, each driving part 210 is electrically connected to a large board (not shown) inside the heat dissipation case 300 to obtain the periodically varying electric field.

Apparently, the present disclosure is not limited thereto. Power may also be supplied to each driving part by an external driving module (e.g., an external power supply).

In the present disclosure, the specific structure of the heat dissipation case 300 is not particularly limited. As an alternative implementation, the heat dissipation case 300 may include a case bottom plate 310 and a case side plate 320. The case side plate 320 is provided at a side edge of the case bottom plate 310, a first sealing member is provided between the case bottom plate 310 and the enhanced heat dissipation assembly 200, and a second sealing member is provided between the case side plate 320 and the enhanced heat dissipation assembly 200.

By means of the first and second sealing members, electromagnetic leakage can be avoided, and the driving part can be ensured to obtain a relatively large vibration amplitude to cause the vibration piece to drive an air flow at a higher flow rate, thereby achieving a better heat dissipation effect. Meanwhile, by means of the first and second sealing members, the resistance to external electromagnetic interference of the driving part 210 can be also enhanced.

As a second aspect of the present disclosure, there is provided base station equipment including a heat dissipation device being the heat dissipation device according to the first aspect of the present disclosure.

The base station equipment includes the heat dissipation device with a good heat dissipation effect as discussed above, so that the base station equipment can be prevented from being overheated, the service performance of the base station equipment can be improved, and the service life of the base station equipment can be prolonged.

The present disclosure has disclosed exemplary embodiments, and although specific terms are employed, they are used and should be interpreted merely in a generic and descriptive sense, not for purposes of limitation. In some instances, as would be apparent to one skilled in the art, features, characteristics and/or elements described in connection with a particular embodiment may be used alone or in combination with features, characteristics and/or elements described in connection with another embodiment, unless expressly stated otherwise. It will, therefore, be understood by those skilled in the art that various changes in form and details may be made therein without departing from the scope of the present disclosure as set forth in the appended claims.

## Claims

1. A heat dissipation device, comprising a heat dissipation body, wherein
the heat dissipation device further comprises an enhanced heat dissipation assembly comprising at least one driving part and at least one vibration piece, each vibration piece is connected to a corresponding driving part, and the driving part is configured to vibrate under an excitation condition and drive the vibration piece to vibrate, so as to form an airflow to assist heat dissipation through the heat dissipation body.

2. The heat dissipation device according to claim 1, wherein the excitation condition comprises a periodically varying electric field, the driving part comprises an electric signal receiving portion and a connecting portion, the electric signal receiving portion is configured to receive the periodically varying electric field, the connecting portion is made of a piezoelectric material, the connecting portion is electrically connected to the electric signal receiving portion so that the electric signal receiving portion transmits the received electric field to the connecting portion, and the connecting portion is further connected to the vibration piece.

3. The heat dissipation device according to claim 2, wherein one end of the vibration piece is connected to the connecting portion, and the other end of the vibration piece is a free end.

4. The heat dissipation device according to any one of claims 1 to 3, the heat dissipation device further comprises a heat dissipation case on which the heat dissipation body and the enhanced heat dissipation assembly are provided.

5. The heat dissipation device according to claim 4, wherein the enhanced heat dissipation assembly is provided at a bottom of the heat dissipation case.

6. The heat dissipation device according to any one of claims 1 to 5, wherein the heat dissipation body comprises a plurality of heat dissipation teeth arranged at intervals, and a length direction of the heat dissipation teeth coincides with a length direction of the vibration piece.

7. The heat dissipation device according to claim 6, wherein the vibration piece is provided in a gap between two adjacent heat dissipation teeth.

8. The heat dissipation device according to claim 5, wherein the enhanced heat dissipation assembly and the heat dissipation body are arranged in sequence in a height direction of the heat dissipation case.

9. The heat dissipation device according to claim 4 or 5, wherein the heat dissipation device further comprises an enhanced heat dissipation cover fixedly connected to the heat dissipation case, an enhanced heat dissipation through hole is formed in the enhanced heat dissipation cover, and the enhanced heat dissipation assembly is provided in a space between the enhanced heat dissipation cover and the heat dissipation case.

10. The heat dissipation device according to claim 4 or 5, wherein the heat dissipation device comprises a heat dissipation body cover fixedly connected to the heat dissipation case, at least part of the heat dissipation body is located in a space between the heat dissipation case and the heat dissipation body cover, and a body heat dissipation through hole is formed in the heat dissipation body cover.

11. The heat dissipation device according to claim 4 or 5, wherein the enhanced heat dissipation assembly comprises a plurality of vibration pieces and a plurality of driving parts, and the enhanced heat dissipation assembly further comprises a setting plate on which the vibration pieces are arranged at intervals, wherein the free end of each vibration piece protrudes out of an edge of the setting plate, and the free end of each of the plurality of vibration pieces faces a top of the heat dissipation case.

12. The heat dissipation device according to claim 11, wherein a first positioning member is provided on the heat dissipation case, a second positioning member is provided on the setting plate, and the first positioning member is matched with the second positioning member.

13. The heat dissipation device according to claim 4 or 5, wherein each of the driving parts is electrically connected to a large board inside the heat dissipation case to obtain a periodically varying electric field.

14. The heat dissipation device according to claim 4 or 5, wherein the heat dissipation case comprises a case bottom plate and a case side plate, the case side plate is provided at a side edge of the case bottom plate, a first sealing member is provided between the case bottom plate and the enhanced heat dissipation assembly, and a second sealing member is provided between the case side plate and the enhanced heat dissipation assembly.

15. Base station equipment, comprising a heat dissipation device being the heat dissipation device according to any one of claims 1 to 14.
